# EUROPEAN PATENT SPECIFICATION

(11) **EP 3 803 120 B1**
(45) Date of publication and mention of the grant of the patent: **05.07.2023**
(21) Application number: 19855910.6
(22) Date of filing: 08.05.2019
(51) Int. Cl.: F04B 35/04, F04B 39/12, F04B 39/02, F04B 39/14, F04C 29/00, F25B 31/02, H05K 5/02, H05K 5/03

(54) **AN ELECTRONIC CARD HOUSING MOUNTED TO A COMPRESSOR**
AN EINEM VERDICHTER MONTIERTES GEHÄUSE EINER ELEKTRONISCHEN KARTE
BOÎTIER POUR CARTES ÉLECTRONIQUES MONTÉ SUR UN COMPRESSEUR

(30) Priority: 29.05.2018 TR 201807603
(43) Date of publication of application: 14.04.2021
(73) Proprietor: Arçelik Anonim Sirketi, 34445 Istanbul (TR)
(72) Inventor: CETINTURK, Tugba, 34445 Beyoglu/Istanbul (TR); DUMLU, Bekir, 34445 Beyoglu/Istanbul (TR); GUNAYDIN, Metin, 34445 Beyoglu/Istanbul (TR); GUNDUZ, Cihan, 34445 Beyoglu/Istanbul (TR); BATUR, Yasin, 34445 Beyoglu/Istanbul (TR)
(86) International application number: PCT/TR2019/050304
(87) International publication number: WO 2020/046231

(56) References cited:
- EP-A2- 3 196 461
- WO-A1-2017/076465
- JP-A- 2000 087 855
- JP-A- 2004 039 654

## Description

The present invention relates to a housing for an electronic card, preferably for a control card, mounted particularly to hermetic compressors.

Variable capacity hermetic compressors used particularly in coolers, are driven by electronic control cards. A control card housing in which control cards, e.g. an inverter card is fastened, is electrically connected to a compressor body by means of sockets provided thereon and is mechanically mounted on the compressor body by means of at least one fastening member. When mounting a control card housing, at first, electrical connections are established and then the housing is fastened on the body.

When the control card malfunctions, it is required to physically access the electronic card to download a software to, update or test the card. To that end, the card should be electrically and mechanically dismounted from the compressor. Such an assembly disassembly operation leads to a great loss of time and also damages the housing, which in turn increases the labor and spare part costs.

State of the art international patent application no. WO2007012961 discloses a control card housing mounted on a compressor, comprising a cover thereon, which can be opened and closed. In this embodiment, the cover remains on the housing in both of its positions. Another state of the art embodiment is the European patent application no. EP1111316. This document discloses a control card housing mounted on a compressor, comprising a detachable cover.

Other state of the art documents, the European patent application no. EP3196461 and the International patent application no. WO2017076465 also disclose a control card housing mounted on a compressor.

The aim of the present invention is to realize a control card housing enabling effective software and hardware maintainability of an electronic card placed therein.

The housing realized to achieve the aim of the present invention and disclosed in the first claim and the dependent claims, comprises at least one opening disposed on the portion where one or more pins are provided on an electronic card located in the housing for establishing data and/or electrical connections, wherein the opening enables the pins to be externally accessed, and at least one cover enabling said opening to be covered and uncovered.

The cover and the opening are conformingly shaped and are both rectangular in the preferred embodiment.

The housing of the invention is a housing in which is fastened an inverter card used for controlling hermetic type compressors utilized particularly in coolers and/or freezers. When it is required to make an operation on the electronic card, the cover on the housing is opened and the pins can be easily accessed through the opening. This enables rapid, easy and effective execution of software installation, data collection, testing and similar maintenance activities particularly on inverter cards. It is not required to dismantle the housing from the compressor during such activities. This enables minimizing the amount of deformation and scraps occurring on electronic cards, housings, cables and other parts during assembly and disassembly operations.

In the preferred embodiment of the invention, the housing consists of two pieces, namely a lower and an upper piece. The opening is disposed on the side wall of the lower piece, exactly at the region corresponding to the portion accommodating the pins to which data and/or electrical connections are to be established. In this embodiment, the cover moves between the first and the second pieces on the opening, so as to cover and uncover the opening.

In an embodiment of the invention, the housing comprises a movement mechanism on which the cover is mounted. The movement mechanism comprises two rails provided parallel to each other on the lower and the upper pieces, enabling the cover to slidingly move on the opening. In this embodiment, when it is desired to access the card, the cover is slid inside the rails, enabling it to uncover the opening, and maintenance is executed by reaching the pins arranged right behind the opening. When the operation is completed, the cover is moved on the opening by being slid on the rails again, enabling the cover to cover the opening. By this, an electronic card in the housing is easily and effectively maintained without disassembling the housing from the compressor on which it is fastened and without causing deformations.

In an embodiment of the invention, the housing comprises a handle provided on the cover, forming an outwards projection on the cover and enabling an operator to easily grip and move the cover.

In another embodiment of the invention, the housing comprises a locking mechanism inhibiting the cover from opening unintentionally and from being detached from the housing. In this embodiment, the locking mechanism comprises a stopper disposed right next to the opening, on the side wall of the housing. The stopper prevents the cover in closed position from opening unintentionally.

The present invention enables rapid, easy and effective execution of software installation, data collection, testing and similar maintenance activities particularly on inverter cards. In addition, the amount of deformation and scraps occurring on electronic cards, housings, cables and other parts are minimized.

A housing realized to achieve the aims of the present invention is illustrated in the accompanying drawings, wherein:
Figure 1 is a side view of a compressor and the housing mounted to the compressor.
Figure 2 is a perspective view of the compressor and the housing before being assembled to each other.
Figure 3 is an exploded perspective view of the housing and the cover thereon.
Figure 4 is a perspective view of the housing and the electronic card therein with the cover opened.
Figure 5 is a perspective view of the housing and the electronic card therein with the cover closed, from a different angle.

The elements in the figures are numbered individually and the correspondence of these numbers are given hereinafter.
1. Compressor
2. Body
3. Bracket
4. Terminal socket
5. Grounding socket
6. Card
7. Pin
8. Housing
9. First piece
10. Second piece
11. Side wall
12. Opening
13. Cover
14. Rail
15. Handle
16. Stopper

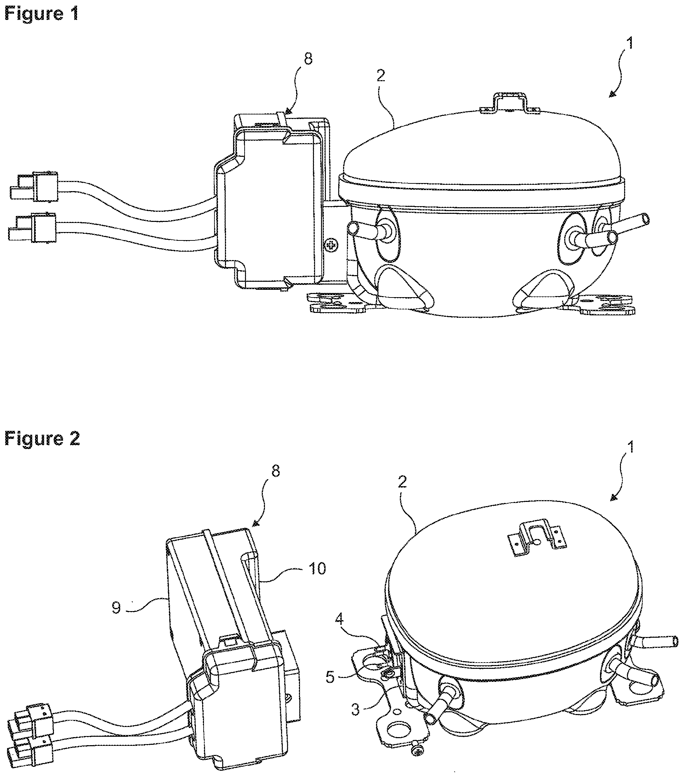

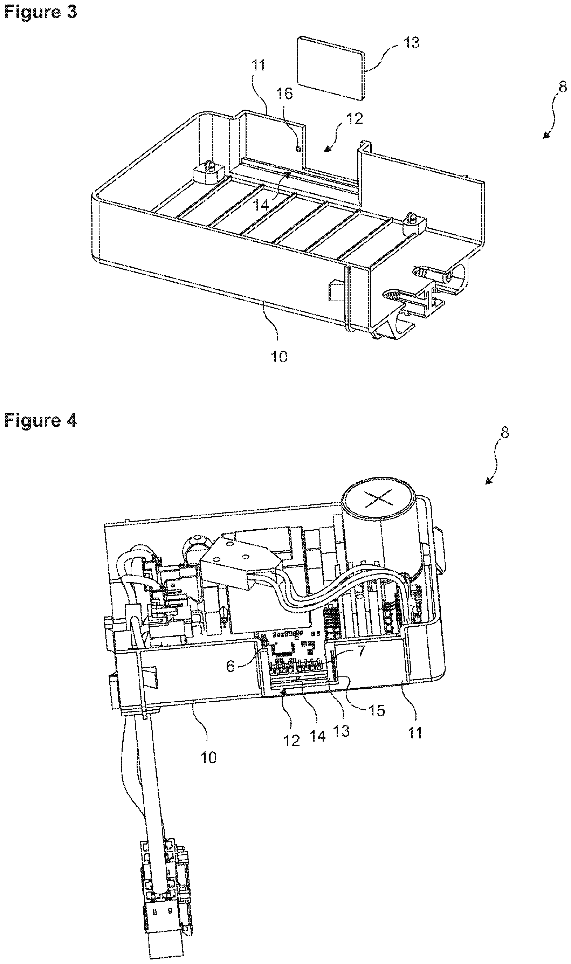

The housing (8) of the invention is adapted to be used in a compressor (1) by being fastened thereon (Figure 1 and Figure 2), and comprises at least one opening (12) disposed at the region corresponding to the portion of an electronic card (6) provided in the housing (8), accommodating one or more pins (7) to which data and/or electrical connections are to be established, wherein the opening (12) enables the pins (7) to be externally accessed, and the housing (8) further comprises at least one cover (13) enabling said opening (12) to be covered and uncovered (Figure 3).

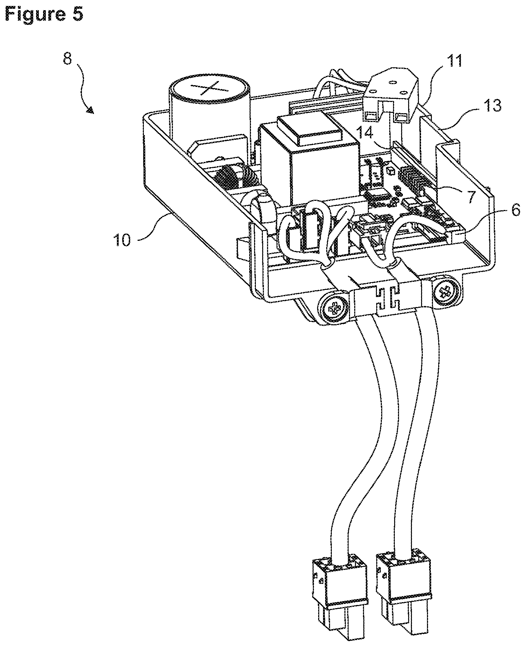

When it is required to make an operation on the electronic card (6), the cover (13) on the housing (8) is opened and the pins (7) can be easily accessed through the opening (12). This enables rapid, easy and effective execution of software installation, data collection, testing and similar maintenance activities particularly on inverter electronic cards (6). It is not required to dismantle the housing (8) from the compressor (1) during such activities. This enables minimizing the amount of deformation and scraps occurring on electronic cards (6), housings (8), cables and other parts during assembly and disassembly operations (Figure 4 and Figure 5).

The compressor (1) on which the housing (8) is fastened, comprises a body (2), an electrical connection member provided on the body (2) and at least one mechanical connection member. The electrical connection member consists of a terminal socket (4) and a grounding socket (5). Correspondingly, the card (6) comprises a terminal plug connecting to the terminal socket (4) and a grounding plug connecting to the grounding socket (5). The housing (8) is fastened on the body (2) by means of a bracket (3) which is the mechanical connection member.

In the preferred embodiment of the invention, the opening (12) and the cover (13) have the same shape and are rectangular.

In the preferred embodiment of the invention, the housing (8) comprises a first piece (9) shaped as a cover (13) and a second piece (10) shaped as a seat in which the electronic card (6) is placed. The opening (12) is disposed on the side wall (11) of the second piece (10), exactly at the region corresponding to the portion accommodating the pins (7) to which data and/or electrical connections are to be established. In this embodiment, the cover (13) moves between the first and the second pieces (9 and 10) on the opening (12), so as to cover and uncover the opening (12).

In an embodiment of the invention, the housing (8) comprises a movement mechanism on which the cover (13) is mounted, provided on the first piece (9) and the second piece(10). The movement mechanism comprises two rails (14) provided parallel to each other on the first and the second pieces (9 and 10), enabling the cover (13) to slidingly move above the opening (12). In this embodiment, when it is desired to access the card (6), the cover (13) is slid inside the rails (14), enabling it to uncover the opening (12), and maintenance is executed by reaching the pins (7) arranged right behind the opening (12). When the operation is completed, the cover (13) is moved above the opening (12) by being slid on the rails (14) again, enabling the cover (13) to cover the opening (12). By this, an electronic card (6) in the housing (8) is easily and effectively maintained without disassembling the housing (8) from the compressor (1) on which it is fastened and without causing deformations.

In an embodiment of the invention, the housing (8) comprises a handle (15) provided on the cover (13), forming an outwards projection on the cover (13) and enabling an operator to easily grip and move the cover (13).

In another embodiment of the invention, the housing (8) comprises a locking mechanism inhibiting the cover (13) from opening unintentionally and from being detached from the housing (8). In this embodiment, the locking mechanism comprises a stopper (16) disposed right next to the opening (12), on the side wall of the housing (8). The stopper (16) prevents the cover (13) in closed position from opening unintentionally.

The compressor (1) of the invention is a hermetic type compressor (1).

The compressor (1) of the invention is used in coolers and/or freezers.

The present invention enables rapid, easy and effective execution of software installation, data collection, testing and similar maintenance activities particularly on inverter electronic cards (6). In addition, the amount of deformation and scraps occurring on electronic cards (6), housings (8), cables and other parts are minimized.

## Claims

1. A control card housing (8) adapted to be used in a compressor (1) by being fastened thereon, comprising a first piece (9) shaped as a cover; a second piece (10) shaped as a seat in which an electronic card (6) is placed; at least one opening (12) for externally accessing, when the electronic card (6) is placed in the housing (8), one or more data and/or electrical connection pins (7) of the electronic card (6); and at least one cover (13) enabling said opening (12) to be covered and uncovered; **characterized by** the opening (12) disposed on a side wall (11) of the second piece (10), at the region corresponding to the electronic card portion accommodating the pins (7), and the cover (13) being adapted to move between the first piece (9) and the second piece (10) on the opening (12), so as to cover and uncover the opening (12).

2. A housing (8) according to claim 1, **characterized by** a movement mechanism on which the cover (13) is mounted, provided on the first and the second pieces (9 and 10).

3. A housing (8) according to claim 2,
**characterized by** the movement mechanism comprising two rails (14) provided parallel to each other on the first and the second pieces (9 and 10), enabling the cover (13) to slidingly move above the opening (12).

4. A housing (8) according to any one of the preceding claims, **characterized by** a handle (15) provided on the cover (13), forming an outwards projection on the cover (13) and enabling an operator to easily grip and move the cover (13).

5. A housing (8) according to any one of the preceding claims, **characterized by** a locking mechanism inhibiting the cover (13) from opening unintentionally and from being detached from the housing (8).

6. A housing (8) according to claim 5, **characterized by** the locking mechanism comprising a stopper (16) disposed right next to the opening (12), on the side wall of the housing (8).

7. A housing (8) according to any one of the preceding claims, **characterized by** the rectangular opening (12) and by the cover (13) having the same shape as the opening (12).

## Patentansprüche

1. Ein Steuerkartengehäuse (8), das angepasst ist, in einem Kompressor (1) verwendet zu werden, indem es daran befestigt wird, **umfasst** ein erstes Stück (9), das als Abdeckung geformt ist; ein zweites Stück (10), das als Sitz geformt ist, in dem eine elektronische Karte (6) angeordnet ist; mindestens eine Öffnung (12) für den externen Zugriff auf einen oder mehrere Daten und/oder elektrische Verbindungsstifte (7) der elektronischen Karte (6), wenn die elektronische Karte (6) in dem Gehäuse (8) angeordnet ist; und mindestens eine Abdeckung (13), die es ermöglicht, die Öffnung (12) abzudecken und freizugeben; **gekennzeichnet ist es durch** die Öffnung (12), die an einer Seitenwand (11) des zweiten Teils (10) in dem Bereich angeordnet ist, der dem Abschnitt der elektronischen Karte entspricht, der die Verbindungsstifte (7) aufnimmt, und die Abdeckung (13) dafür ausgelegt ist, sich zwischen dem ersten Teil (9) und dem zweiten Teil (10) auf der Öffnung (12) zu bewegen, um die Öffnung (12) abzudecken und freizugeben.

2. Ein Gehäuse (8), wie in Anspruch 1 aufgeführt, **ist dadurch gekennzeichnet, dass** der Bewegungsmechanismus, an dem die Abdeckung (13) montiert ist, an dem ersten und dem zweiten Stück (9 und 10) vorgesehen ist.

3. Ein Gehäuse (8), wie in Anspruch 2 aufgeführt, **ist dadurch gekennzeichnet, dass** der Bewegungsmechanismus zwei Schienen (14) umfasst, die parallel zueinander an dem ersten und dem zweiten Teil (9 und 10) vorgesehen sind, wodurch es der Abdeckung (13) ermöglicht wird, sich gleitend über der Öffnung (12) zu bewegen.

4. Ein Gehäuse (8), wie in einem der vorherigen Ansprüchen aufgeführt, **ist dadurch gekennzeichnet, dass** ein Griff (15) an der Abdeckung (13) vorgesehen ist, der einen nach außen gerichteten Vorsprung an der Abdeckung (13) bildet und es einem Bediener ermöglicht, die Abdeckung (13) leicht zu greifen und zu bewegen.

5. Ein Gehäuse (8), wie in einem der vorherigen Ansprüchen aufgeführt, **ist dadurch gekennzeichnet, dass** ein Verriegelungsmechanismus verhindert, dass die Abdeckung (13) unbeabsichtigt geöffnet und von dem Gehäuse (8) gelöst werden kann.

6. Ein Gehäuse (8), wie in Anspruch 5 aufgeführt, **ist dadurch gekennzeichnet, dass** der Verriegelungsmechanismus einen unmittelbar neben der Öffnung (12) an der Seitenwand des Gehäuses (8) angeordneten Stopfen (16) umfasst.

7. Ein Gehäuse (8), wie in einem der vorherigen Ansprüchen aufgeführt, **ist dadurch gekennzeichnet, dass** die rechteckige Öffnung (12) und die Abdeckung (13) die gleiche Form wie die Öffnung (12) haben.

## Revendications

1. Un boîtier de carte de commande (8) adapté pour être utilisé dans un compresseur (1) en étant fixé sur celui-ci, comprenant une première pièce (9) en forme de couvercle ; une seconde pièce (10) en forme de siège dans lequel une carte électronique (6) est placée ; au moins une ouverture (12) pour accéder de l'extérieur, lorsque la carte électronique (6) est placée dans le boîtier (8), à une ou plusieurs broches de connexion de données et/ou électrique (7) de la carte électronique (6) ;et au moins un couvercle (13) permettant à ladite ouverture (12) d'être couverte et découverte ; **caractérisé par le fait que** l'ouverture (12) est disposée sur une paroi latérale (11) de la seconde pièce (10), au niveau de la région correspondant à la partie de carte électronique recevant les broches (7), et le couvercle (13) est adapté pour se déplacer entre la première pièce (9) et la seconde pièce (10) sur l'ouverture (12), de manière à couvrir et découvrir l'ouverture (12).

2. Un boîtier (8) selon la déclaration 1, **caractérisé par** un mécanisme de mouvement sur lequel le couvercle (13) est monté, prévu sur les première et deuxième pièces (9 et 10).

3. Un boîtier (8) selon la déclaration 2, **caractérisé par** le mécanisme de mouvement comprenant deux rails (14) prévus parallèlement l'un à l'autre sur la première et la deuxième pièce (9 et 10), permettant au couvercle (13) de se déplacer de manière coulissante au-dessus de l'ouverture (12).

4. Un boîtier (8) selon l'une quelconque des déclarations précédentes, **caractérisé par** une poignée (15) prévue sur le couvercle (13), formant une saillie vers l'extérieur sur le couvercle (13) et permettant à un opérateur de saisir et de déplacer facilement le couvercle (13).

5. Un boîtier (8) selon l'une quelconque des déclarations précédentes, **caractérisé par** un mécanisme de verrouillage empêchant le couvercle (13) de s'ouvrir involontairement et de se détacher du boîtier (8).

6. Un boîtier (8) selon la déclaration 5, **caractérisé par** le mécanisme de verrouillage comprenant un bouchon (16) disposé juste à côté de l'ouverture (12), sur la paroi latérale du boîtier (8).

7. Un boîtier (8) selon l'une quelconque des déclarations précédentes, **caractérisé par** l'ouverture rectangulaire (12) et par le couvercle (13) ayant la même forme que l'ouverture (12).
